# EUROPEAN PATENT SPECIFICATION

(11) **EP 1 507 173 B1**
(45) Date of publication and mention of the grant of the patent: **25.05.2011**
(21) Application number: 04077235.2
(22) Date of filing: 04.08.2004
(51) Int. Cl.: G03F 7/20

(54) **Lithographic apparatus and apparatus adjustment method**
Lithographischer Apparat und Justierverfahren für den Apparat
Appareil lithographique et methode d'ajustage de cet appareil

(30) Priority: 12.08.2003 EP 03077530
(43) Date of publication of application: 16.02.2005
(73) Proprietor: ASML Netherlands B.V., 5504 DR Veldhoven (NL)
(72) Inventor: Vink, Jacob Willem, 5653 RM Eindhoven (NL); Modderman, Theodorus Marinus, 5672 HW Nuenen (NL); Donders, Sjoerd Nicolaas Lambertus, 5211 HN 's-Hertogenbosch (NL); Cadee, Theodorus Petrus Maria, 5656 BJ Vlierden (NL)
(74) Representative: van Os, Lodewijk Hubertus

(56) References cited:
- EP-A- 0 480 616
- US-A- 5 094 536
- US-A1- 2002 117 792
- US-B1- 6 556 281

## Description

The present invention relates to a lithographic projection apparatus comprising a beam production system for providing a projection beam of radiation, patterning the beam and projecting the patterned beam onto a target portion of a substrate as defined in claim 1. The beam production system typically comprises:
- a radiation system for supplying a projection beam of radiation;
- a support structure for supporting patterning means, the patterning means serving to pattern the projection beam according to a desired pattern;
- a projection system for projecting the patterned beam onto a target portion of the substrate.

The term "patterning means" as here employer should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, cleaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096 . In the case of a programmable mirror array, the said support structure may be embodied as a frame or table, for example, which may be fixed or movable as required.
- A programmable LCD array. An example of such a constriction is given in United States Patent US 5,229,572 . As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792 .

In a manufacturing process using a lithographic projection apparatus, a pattern (*e.g.* in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e.g.* an IC. Such a patterned layer may then undergo various processes such as etching, ion-implantation (doping), metallization, oxidation, chemo-mechanical polishing, etc., all intended to finish off an individual layer. If several, layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van. Zant, McGraw Hill Publishing Co., 1997, ISBN 0-07-067250-4 .

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiply stage" devices the additional tables may be used in parallel, or preparatory steps may be carried out on one or more tables while one or more other tables are being used for exposures. Dual stage lithographic apparatus are described, for example, in US 5,969,441 and WO 98/407911.

European patent Application No 1093022 and corresponding US patent No. 6, 392, 738 address cleaning of the substrate support table. The substrate support tables used in lithography have a support surface with protrusions that extend substantially perpendicularly from the surface. In operation the backside of the substrate is supported on the protrusions, at a small distance from the support surface of the substrate table, in a position substantially perpendicular to the direction of propagation of the projection beam. Thus, the tops of the protrusions, rather than the support surface of the wafer table, define an effective support surface for the substrate.

EP1093022 and US6,392,738 describe that contamination present between the backside of the substrate and the protrusions can produce a deformation of the surface of the substrate with detrimental imaging effects. To solve this problem these documents disclose a detector for recognizing the presence of contamination. Preferable, the presence of contamination is recognized from unevenness of the surface of a substrate on the substrate support table. A suitable device for sensing the level of the substrate is already available, since it is used to adjust the height and tilt of the substrate during exposure.

The documents also disclose cleaning tools for removing contamination from the protrusions. These cleaning tools include a ceramic cleaning block that can be positioned against the support surface and moved in parallel to it to remove contamination by abrasive cleaning. Another embodiment of the cleaning tool includes a sponge provided with a solvent for removing contamination. A further embodiment includes a laser for removing the contamination by heat treatment.

EP1093022 and US6,392,738 emphasize that measures should be taken not to damage the protrusions themselves when the contamination is removed. In the embodiment of the cleaning block, for example the forces exerted by the cleaning block should not be so excessive as to damage the protrusions.

Unevenness of the supporting surface can also be caused by dissimilarity between the heights of material that makes up the protrusion itself. This is typically the case when a new substrate support table has been manufactured. Possibly uneven wear may also lead to unevenness. The substrate support table typically contains a chuck on which the table with the protrusions is supported. Unevenness may be the result of differences between the height of the protrusions, or in the backside of the table or in the chuck. Therefore these elements are carefully made level. Nevertheless it has been found that unevenness may also result when the chuck and the support table (and any other elements) are assembled or installed.

Similar problems may be encountered with support tables for other articles that have to be supported in a well-defined plane across the beam path, such as reflective masks or transmission masks.

US Patent No. 5,094,536 discloses a wafer chuck with protrusions to support a wafer. Each protrusion comprises an electrically controllable actuator such as a piezo-electric crystal with an extension pin on its upper surface. The actuators exhibit elongation or shortening when an electric fiels is applied thereto. A wafer rests on the extension pins. Surface flatness of the wafer is monitored while the wafer is supported by the pins and the electric field applied to the actuators is varied to perform fine control of wafer deformation.

US 2002/008864 A discloses a lithographic projection apparatus comprising a support table, the support table having an array of protrusions.

It is an object of the present invention to provide an improved lithographic projection apparatus and a method of operating such an apparatus, in which the effects of unevenness of the protrusions on a support table is counteracted.

The lithographic projection apparatus according to the invention is characterized by the characterizing part of Claim 1. According to the invention an *in situ* height adjustement device is used to alter the height of the material that at least the top of individual protrusions are integrally made of, when the support table is at an operable position in the lithographic projection apparatus. (By "operable" it is meant that the support table can be moved to a pattern projection position in the apparatus from the operable position without movements that are more disruptive to the support table assembly than during normal use; "integrally made" refers to material that is used to manufacture the support table, but not to accidental foreign material such as pollution). By adjusting the height of the protrusions in the assembled support table in the lithographic apparatus, at such an operable position, a most reliable height adjustment is realized.

A detector determines which of the protrusions have a height deviation and a control unit controls the height adjustment device for example to remove a part of the material of selected protrusions with excess height, but not from other protrusions that do not have an excess height, or an excess height below a threshold. In a preferred embodiment the apparatus only contains a material removing device, no material being added to the protrusions.

In another example the height adjustment device is used to heat selected protrusions that have a height deficit to make their material assume a semi-permanent swelled phase, which increases the height of the protrusion. The height adjustment device applies this treatment to selected protrusions: it does not cause material of protrusions to assume the swelled phase semi-permanently if they do not have a height deficit, or a height deficit below a threshold. As used herein an "at least semi-permanent swelled phase" refers to a solid state phase that remains after the material has cooled down to normal operating temperature during a period of normal operation, for example at least until renewed heating.

Preferably, the height deviation is determined by measuring the height profile of the planar surface of an article on the support table (for example a calibration substrate that has substantially known, preferably flat, thickness profile) that rests on the protrusions and computing the excess heights from the measured height profile.

In an embodiment the material removing device doubles as a device for removing contamination from the protrusions. Such as disclosed in EP1093022. The difference is that in this embodiment according to the present invention the material removing device is arranged to operate on individual protrusions independently and that the removing strength of the material removing device is adjustable from a low level, at which only contamination is removed, to a high level where material that makes up the protrusions is removed as well. This may be realized, for example when the removing device uses a laser beam by increasing the power of the laser beam and/or the duration of the interval that it is directed at a particular protrusion; when the removing device uses an abrasive block this may be realized by increasing the force with which the block is pressed against the particular protrusion, or by using different material or surface properties (i.e. roughness) for the abrasive block.

Preferably, the control unit controls the amount of material that is removed dependent on the measured amount of excessive height. This may be realized for example, when the removing device uses a laser beam, by controlling the duration with which the laser beam is directed at a particular protrusion with a high power level, or a polishing duration when mechanical polishing is used. As an alternative, an arbitrary or fixed amount of material may be removed from protrusions with excess height, the process of measuring and removing being repeated until sufficient flatness has been achieved.

The invention also relates to a method of adjusting a height of protrusions on a support surface of a support table for holding an article with a planar surface in a predetermined plane transverse to a beam path in a lithographic projection apparatus, as defined in claim 11. (As used herein "array" refers to any spatial arrangement of protrusions, not just to spatially periodic arrangements).

By adjusting the heights in the assembled state of the support table unevenness due to assembly can be removed. Preferably this correction is executed in situ in the lithographic projection apparatus, to prevent that installation of the support table can affect the final uneveness.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 2048, 1064, 532, 365, 248, 193, 157 or 126 nm and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 shows a substrate table
Figure 3 shows a top view of an illumination table
Figure 4 shows an embodiment of a material removing device
Figure 5 shows a control sub-system of a lithographic apparatus
Figure 6 shows a measuring device

### Embodiment 1

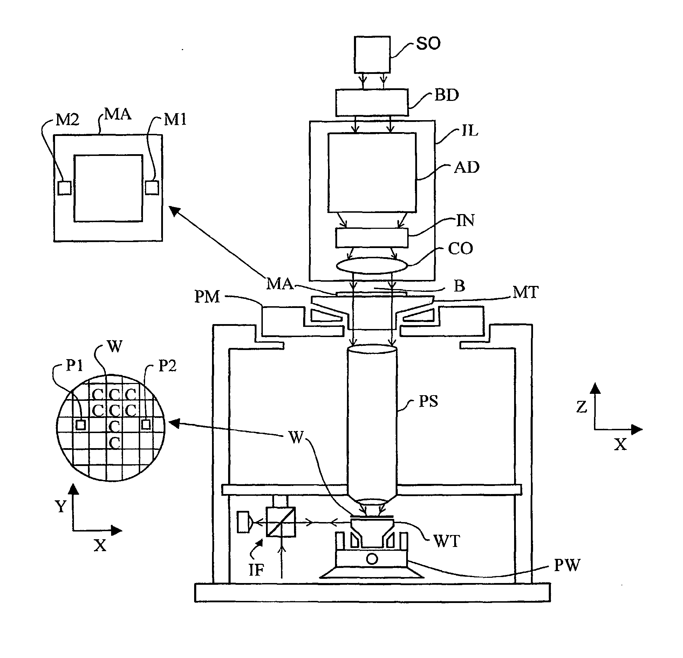

Figure 1 schematically depicts a lithographic projection apparatus according to a particular embodiment of the invention. The apparatus comprises:
· a radiation system Ex, IL, for supplying a projection beam PB of radiation (*e*.*g*. EUV radiation), which in this particular case also comprises a radiation source LA;
· a first object table (mask table) MT provided with a mask holder for holding a mask MA (*e.g.* a reticle), and connected to first positioning means PM for accurately positioning the mask with respect to item PL;
· a second object table (substrate table) WT provided with a substrate holder for holding a substrate W (*e.g.* a resist-coated silicon wafer), and
· connected to second positioning means PW for accurately positioning the substrate with respect to item PL;
· a projection system ("lens") PL (*e.g.* a mirror group) for imaging an irradiated portion of the mask MA onto a target portion C (*e.g.* comprising one or more dies) of the substrate W.
As here depicted, the apparatus is of a reflective type (*i.e.* has a reflective mask). However, in general, it may also be of a transmissive type, for example (with a transmissive mask). Alternatively, the apparatus may employ another kind of patterning means, such as a programmable mirror array of a type as referred to above.

The source LA (*e.g.* a discharge or laser-produced plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means PM can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
In scan mode, essentially the same scenario applies, except that a given target portion C is not exposed in a single "flash". Instead, the mask table MT is movable in a given direction (the so-called "scan direction", *e.g.* the y direction) with a speed υ, so that the projection beam PB is caused to scan over a mask image; concurrently, the substrate table WT is simultaneously moved in the same or opposite direction at a speed *V = M*υ, in which *M* is the magnification of the lens PL (typically, *M* = 1/4 or 1/5). In this manner, a relatively large target portion C can be exposed, without having to compromise on resolution.

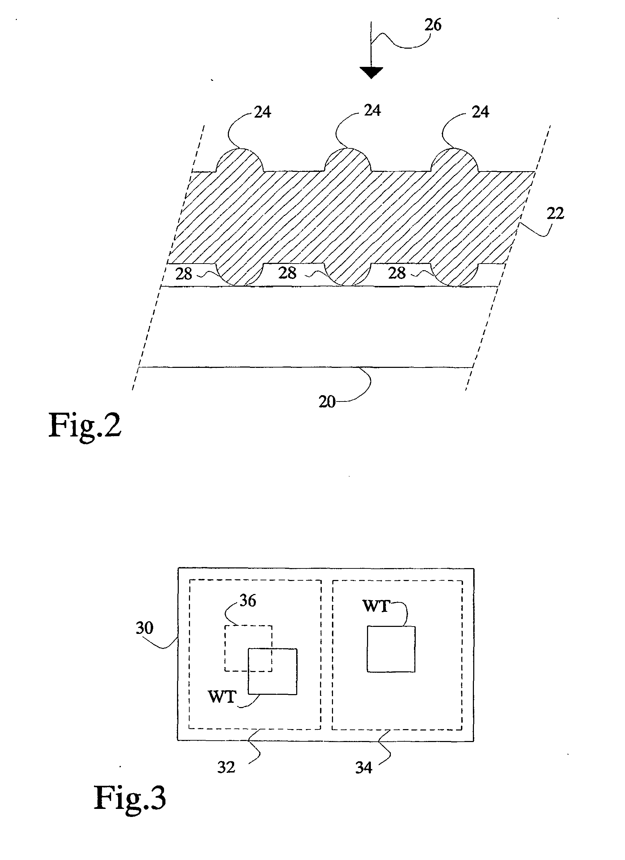

Figure 2 shows a cross section of part of substrate table WT (not to scale). Substrate table WT comprises a movable chuck 20, with a table 22 thereon. The propagation direction 26 of projection beam PB is transverse to the surface of table 22. The surface of table 22 is provided with a pattern of protrusions 24 (sometimes called pimples or burls). The tops of protrusions 24 define a support surface. In operation a substrate (not shown) is placed on top of table 22, where the backside of the substrate is supported by protrusions 24, so that the backside of the substrate follows the support surface. Similarly, the backside of table 22 is provided with further protrusions 28 via which table 22 rests on chuck 20.

Protrusions 24 typically have a size in the order of a millimeter and are provided at mutual distances of the order of several millimeters. Typically, both table 22 and protrusions 24 may both be made of a ceramic material. However, it should be realized that these dimensions and this material are merely a suitable example and do not limit the invention.

Figure 3 shows a top view of the illumination table 30 within the photolithographic apparatus, wherein the substrate table is located. An illumination area 32 and a preparation area 34 are indicated. In each area 32, 34 a substrate table WT is shown. In operation the projection beam impinges in a region 36 in the illumination area. One table with a substrate W on it is illuminated with projection beam PB in illumination area 32 while the other table is prepared in preparation area 34. Thus, tables WT remain with the photolithographic apparatus.

Differences between the heights of the tops of different protrusions 24 induce unevenness of the surface of substrate WT, which may give rise to imaging errors during illumination with the projection beam PB. In modern photolithographic equipment very small differences between the heights, of the order of tens of nanometers, can already be noticeable. The height differences are due to intrinsic differences between the size of protrusions 24 and further protrusions 28 and unevenness of chuck 20, but also to the interaction of the various components. Therefore it has been found to be desirable to perform a height adjustment step after the substrate table has been assembled, i.e. after table 22 has been placed on chuck 20.

Adjustments of a size of tens of nanometers or higher of the height of protrusions 24 are made by removing part of the material of selected protrusions 24. According to one aspect of the invention adjustment of the height of protrusions 24 is performed in the photolithographic apparatus, on table 30, where substrate tables WT are also located during normal operation.

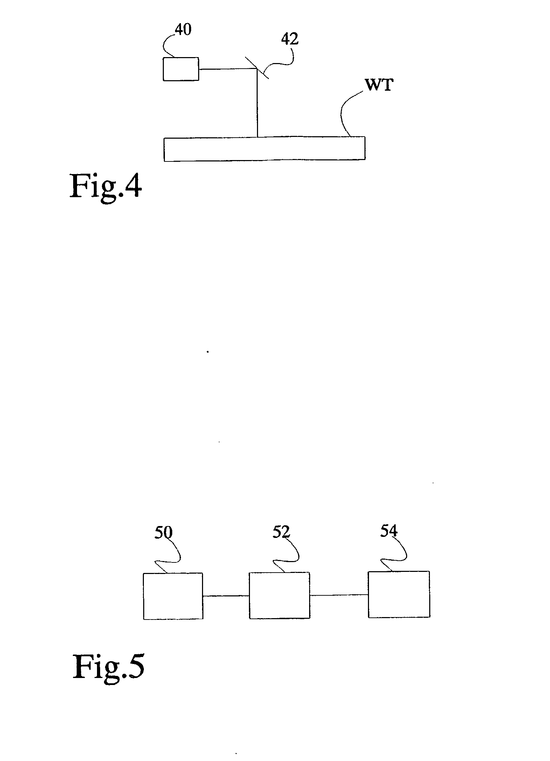

Figure 4 shows an embodiment of a material removing device. The figure shows substrate table WT in side view (no protrusions are shown, because the protrusions are too small to be visible at the scale of the figure). The material removing device contains a laser 40 and a mirror 42. Mirror 42 is used to direct the beam of laser 40 to the surface of table WT. By rotating mirror 42 and/or moving substrate table WT the beam of laser 40 can be directed to the locations of different protrusions on wafer table WT. The beam is used to remove material from the protrusions, e.g. by heating the top of the protrusion so that part of the material of which the protrusion is made evaporates. The beam is focused, or otherwise of such narrow width that, when the intensity of the beam is high enough to remove material from a single protrusion at which the beam is directed, the beam intensity at other protrusions then being so low that substantially no material is removed from those other protrusions (for example because the intensity is insufficient to evaporate material from any the protrusion).

Typically laser 40 is operated in pulsed fashion, irradiating a particular protrusion with a number of "shots" in proportion to the excess height that has been determined for the protrusion. Of course, instead of mirror 42 other ways of changing the location where the laser beam hits substrate table may be used, such as moving substrate table WT or the laser itself.

The device of figure 4 can also be used to increase the height of the protrusions. If has been found that, if the laser power density is set to a level that is insufficient to cause significant evaporation, laser heating may give rise to semi-permanent swelled state of the material of a protrusion after the material has cooled down. Various effects may give rise to such swelling. In one example, the protrusions are made of grains of one material (e.g. Silicon carbide) that are embedded in another material (e.g. Silicon). Heating causes the Silicon to aggregate, which leads to swelling. Such a phase is permanent in the sense that it remains after the protrusion has cooled down. Of course this type of swelling can be realized with other material as well.

Other effects that may be used to cause swelling is the induction of phase separation between different components of the protrusion material due to heating, formation of a glassy phase (i.e. a solid phase with no long range lattice order) instead of a lattice order in the material, or the local formation of a different lattice phase. Formation of a glass phase may be used to create a semi-permanent swelling in the sense that after subsequent heating with slow cooling the protrusion can be returned to a crystalline phase. Usually it is possible to return the material to its original phase.

In an embodiment of the invention the swelled state is used to create a protrusion with increased height. For this purpose the power density of the laser may be adjusted (e.g. by reducing overall laser power or by using a less focused laser beam at the protrusion) so that no significant evaporation of protrusion material occurs, but the phase of the material is locally changed, preferably at the top of the protrusion. The amount of height adjustment may be controlled by adjusting the power dose and the duration of the laser pulse. By using a longer pulse more material is able to migrate and a thicker layer of protrusion material may be affected. Selection of the laser wavelength may also be used to adjust the thickness of the affected layer. It is a matter of simple experimentation to relate experimentally determined height changes to combinations of laser pulse parameters that may be used to adjust the heights.

Figure 5 shows a control sub-system of a lithographic apparatus. The control subsystem contains a measuring device 50 coupled to a processor 52, which in turn is coupled to removing device 54 (the term "removing device" will be used generically in the following, with the understanding that this also covers use of the device to increase the height of the protrusion without removing a significant amount of material).

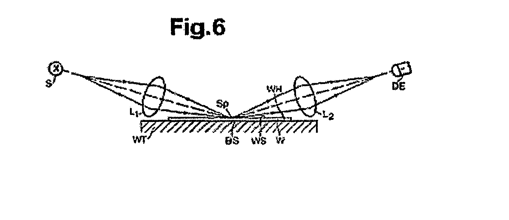

Figure 6 shows a measuring device. This measuring device is a conventional device used for determining unevenness of a substrate W prior to illumination of that substrate with projection beam PB, in order to control focusing corrections during illumination of the substrate. Therefore the measuring apparatus will not be described in detail. Briefly the device measures the level of a substrate W located with its backside BS on substrate table WT. A source of radiation S produces a spot SP on the surface of substrate W from where the radiation is reflected to detector DE, which is constructed to measure changes in height of the reflected radiation when spot SP and substrate W are moved relative to one another. Preferably, the measuring apparatus is also used during normal operation of the apparatus to determine unevenness of a substrate W prior to illumination of the substrate to control focusing corrections during illumination. Of course, different kinds of measuring devices may be used, such as mechanical or pneumatic sensors.

In operation, when a new substrate table has been installed in the lithographic apparatus, processor 52 is made to execute a program for adjusting the heights of the protrusions. Optionally this program is also executed later to correct for wear. When the program is executed a reference substrate of high flatness is first placed on substrate table WT. Preferably, the protrusions are cleaned before the substrate is placed on the protrusions, to remove any contaminant material from the protrusions. This may be done in any known way.

The program causes processor 52 to obtain as series of measurement results from measuring apparatus 50 that are characteristic of the height profile h(r) of the reference substrate on the substrate table WT. Processor 52 stores the results of these measurements. This process may be repeated a number of times with the reference substrate located at different positions on substrate table, and/or with different reference substrates.

Next processor 52 computes whether and which protrusions 24 have a height deviation, and preferably also how the size of the deviation. Typically, this is done by deriving for each particular protrusion a height value of the height profile h(r) in a respective regions of locations "r" on the surface of the reference substrate that overlies the particular protrusion. The height value can be determined in any way. In one embodiment, for example, the excess is determined by sampling the height profile h(r) at a predetermined position r=rₚ relative to the protrusion (preferably right over the protrusion). In another embodiment the excess is determined by integrating (or summing) the measured height profile h(r) of the substrate over a predetermined region that overlies the protrusion, and no other protrusions, optionally weighting the height profile h(r) with a weight function wₚ(r).

In an embodiment, from the collection of height values for all protrusions, processor 52 determines the lowest value, i.e. the height value of the protrusion over which the exposed surface of the substrate is closest to the support table. The difference between the height value for a particular protrusions and this lowest value is called the excess height of the profile for the particular protrusion.

Preferably, the height profiles h(r) from a number of different measurements are combined, the different profiles having been measured with the reference substrate at different positions, or with different substrates, so as to reduce or eliminate effects due to unevenness of the substrate. For example, processor 52 may determine the excess height from the average hₐᵥ of different profiles hᵢ(r) (i=1, 2..) obtained in this way.

From the computed excess heights of the profile for the particular protrusions processor 52 computes the excess height of the underlying protrusion 24. Preferably, an empirically determined relation is used for this purpose, for example a relation determined by measuring the height of the substrate repeatedly, each time after removing a given amount of material from a test protrusion, or after firing a given a number of laser shots at the protrusion 24. The empirical relation may be represented for example by a table that associates a computed value of excess of the substrate to an excess height or a number of laser shots. Instead of a table a polynomial function may be used for example, with empirically determined coefficients.

Subsequently the reference substrate is removed, so that protrusions 24 are exposed. Processor 52 now controls material removing device 54 to aim at a series of protrusions 24 successively, for which an excess height has been detected. When material removing device 54 is aimed at such a protrusion processor controls material removing device 54 to fire a number of shots that is expected to remove the excess height that has been determined for that protrusion. The power level of laser 40 during firing the shots is set to a level that is sufficient to remove material of the protrusion.

When the excess height has been computed directly in terms of the number of shots this is straightforward. Otherwise preferably an empirical relation between the number of shots and the amount of height change may be used to determine the number of shots. Instead of using a series of shots a continuous pulse may be used, processor 52 selecting the duration and/or the intensity of the pulse according to the excess height of protrusion, for example according to a table that relates height reduction of protrusions to the duration and/or intensity. Similarly a combination of pulses with different durations and/or intensities may be used.

In another embodiment from the collection of height values for all protrusions, processor 52 determines the highest value, i.e. the height value of the protrusion over which the exposed surface of the substrate is furthest from to the support table. The difference between the height value for a particular protrusions and this highest value is called the height deficit of the profile for the particular protrusion. Processor 52 now controls material removing device 54 to aim at a series of protrusions 24 successively, for which a height deficit has been detected. When material removing device 54 is aimed at such a protrusion processor controls material removing device 54 to fire a number of shots with a power density that is expected to cause the protrusion to swell with the height deficit that has been determined for that protrusion. In this embodiment the power level of laser 40 during firing the shots is set below a level that is sufficient to remove material of the protrusion.

The material removing and swelling embodiments may be combined, in a process wherein the height of some protrusions is increased by swelling and the height of others is decreased by removal. For this purpose a reference height may be selected, for example an average measured height of the protrusions and protrusions that have a height below this reference height may be made to swell and the height of protrusions above this reference height may be reduced by removal of protrusion material.

It should be appreciated that the invention is not limited to the use of a laser as a material removing device, although of course a laser is especially advantageous because it can conveniently be combined with a lithographic apparatus. Alternative material removing devices include a polishing machine, with a sufficiently small polishing head that can be positioned relative to the wafer table so that at each position an individual protrusion is polished to remove material from that protrusion, substantially without affecting the height other protrusions. In this case the force with which the polishing head is pressed against the protrusion is set to a level that makes it possible to remove material of the protrusion. The force and/or polishing duration are set according to the excess height that has been determined for the protrusion. Any other material removing technique that can be directed at individual protrusions may be used, e.g. abrasion by an electron beam.

In fact it is not even necessary that material can be removed from protrusions individually, as long as the amount of material removed from respective protrusions can be controlled independently. For example, suppose the removing device can be set to different gradients, removing material from more than one protrusion at a time but with a gradient in the removed amount as a function of position of the protrusion. In this case different successive gradient settings can be used to control the removed amount of different protrusions independently of one another.

Although the invention has been described in terms of removal of material, it should be appreciated that, without deviating from the invention the height of the protrusions can also be adjusted by depositing material onto selected protrusions. Any known localized depositing technique, such as sputtering with a source moved close to the protrusion, may be used. In this case an abduction unit or a getter shield is preferably provided in the vicinity of the protrusion to capture excess material that is not deposited on the protrusion. Of course, any combination of a material removing device and a material adding device may be used.

In the case that material is added, the protrusion with the lowest height value need not be used as reference to determine excess height values. Instead the highest height value should be used if only adding of material is possible, to determine the amount of deposition needed to bring the other protrusions level with the protrusion with the highest height value. When both adding and removing is possible, any reference height may be used to draw the protrusions level with. This height may be selected so that only a predetermined small fraction of the protrusions requires added material for example.

It should also be understood that, instead of the described way of computing the height deviations of the protrusions, other methods of determining the height deviations of protrusions may be used. For example, the height profile may be fitted to a model for the height profile, in which the heights of the protrusions are free parameters that are fitted so as to best approximate the measured profile (an example of a model is that the height profile is the sum h(r)=Σ hᵢ b(r+rᵢ) where the sum is over the protrusions, labeled "i", hᵢ is the height of protrusion i and b(r) is the height profile for a protrusion of unit height, which may be determined experimentally or theoretically). Other related statistical estimation techniques may be used as well. Similarly, ways of using the height profiles for the same substrate at different positions that do not merely involve averaging may be used, for example by fitting a model Σ hᵢ { b(r+rᵢ)- b(r+d+rᵢ) } to a measured difference h₁(r)-h₂(r+d) of two profiles obtained for the same reference substrate, with a measured profile h₁(r) at a first position and a second measured profile h₂(r) when the reference substrate has been displaced with respect to the substrate table over an offset "d" with respect to the first position.

Furthermore, it should be realized that, although the invention has been described in terms of height measurements using a substrate located on the substrate table, processor 52 may also used height measurements obtained from the protrusions directly, when the protrusions are uncovered. The advantage of measuring on a substrate is that use can be made of equipment that is already available in the lithographic apparatus for use in normal operation.

Furthermore, it should be realized that, although a single processor 52 has been shown by way of example, the necessary computations and control operation may of course be executed by several processors. Similarly, although measurement and adjustment have been described as consecutive operations, the adjustment may of course be postponed for an arbitrary time after the measurement, allowing other operations to be performed in between.

Also although the invention has been described for a reflective type apparatus, it should be realized that the invention may also be applied to an apparatus that projects the beam through a mask. Furthermore, although the invention has been described for a substrate table, it should be realized that the invention may be applied to a support table for another article in the lithographic projection apparatus, such as a table for supporting a mask or a reticle. Furthermore, although the invention has been described for protrusions that are made entirely of one material, it should be realized that the invention may be applied to protrusions wherein different parts of the protrusion are made of different material, for example by providing a coating layer at least at the top of each protrusion, attached to the underlying part of the protrusion.

Whilst specific embodiments of the invention have been described above, it will be appreciated that the invention may be practiced otherwise than as described. The description is not intended to limit the invention. The invention is defined by the claims.

## Claims

1. A lithographic projection apparatus comprising:
- a beam production system (SO, BD, 1L) for providing a projection beam of radiation, patterning the beam and projecting the patterned beam onto a target portion of a substrate (W);
- a support table (WT, MT) for supporting an article (W, MA) so that a planar surface of the article (W, MA) lies in a predetermined plane transverse to a propagation direction of the projection beam, the support table (WT, MT) having a support surface and an array of protrusions (24) extending from the support surface, so as to support the article (W, MA) on the protrusions (24), at least a top of each protrusion (24) substantially formed of an integral protrusion material, **characterized in that** the lithographic projection apparatus further comprises
- a detector (50, DE) for detecting height deviations of respective ones of the protrusions (24) that affect a surface flatness of the article (W, MA);
- a position selective height adjustment device (54), arranged to act independently on individual protrusions (24) when the support table (WT) is operable in the apparatus, to modify a height of the protrusion material of the individual protrusion (24), the position selective height adjustment device (54) being arranged to remove and/or add material from or to the respective ones of the protrusions (24); and
- a control unit (52) coupled between the detector (50, DE) and the position selective height adjustment device (54) and arranged to control the position selective height adjustment device (54) to adjust the height of the protrusion material corresponding to respective detected height deviations of respective ones of the protrusions.

2. A lithographic projection apparatus according to claim 1, wherein the position selective height adjustment device (54) is arranged to remove material from the respective ones of the protrusions.

3. A lithographic projection apparatus according to claim 2, wherein the position selective height adjustment device (54) is arranged to make material of respective ones of the protrusions (24) assume an at least semi-permanently swelled phase that increases the height of the individual protrusion (24).

4. A lithographic projection apparatus according to claim 1, wherein the article is the substrate (W) or a reticle or mask (MA) that is used to pattern the beam .

5. A lithographic projection apparatus according to claim 1, wherein the position selective height adjustment device (54) is arranged to add material to the respective ones of the protrusions.

6. A lithographic projection apparatus according to claim 2, wherein the position selective height adjustment device (54) is arranged to support an adjustable removing strength, the control unit (52) being switchable between a first mode wherein the removing strength of the position selective height adjustment device (54) is set above a first level sufficient to remove the part of the protrusion material and a second mode wherein the removing strength is set below a second level that is insufficient to remove the part of the protrusion material, but sufficient to remove contaminations of other material from the protrusions (24).

7. A lithographic projection apparatus according to Claim 2, wherein the position selective height adjustment device (54) comprises a laser (40), arranged to project a beam onto selectable ones of the protrusions (24), with an intensity sufficient to cause protrusion material to be removed from the protrusion (24), the control unit (52) being arranged to control respective accumulated power doses delivered by the laser (40) to the respective ones of the protrusion (24) dependent on the height deviations measured for the respective ones of the protrusions (24).

8. A lithographic projection apparatus according to Claim 2, wherein the position selective height adjustment device (54) comprises a laser (40), arranged to project a beam onto selectable ones of the protrusions (24), with an intensity level selected to heat the protrusion material so that it assumes an at least semi-permanently swelled phase after cooling, the control unit (52) being arranged to control an energy density delivered by the laser (40) to the respective ones of the protrusions (24) dependent on the height deviations measured for the respective ones of the protrusions (24).

9. A lithographic projection apparatus according to claim 1, wherein the detector (50, DE) comprises
- a measuring unit (50, DE) for measuring a height profile of the planar surface of the article (W, MA) opposite a further surface of the article that is supported by the support table (WT, MT) ;
- a computation unit (52) arranged to compute the height deviations of the protrusions (24) from the height profile, the control unit (52) controlling the material removing and/or adding device dependent on the height deviation.

10. A lithographic projection apparatus according to claim 1, wherein the position selective height adjustment device (54) comprises a localized material deposition unit, at least one of the support table (WT, MT) and the deposition unit being moveable relative to the other under control of the control unit (52).

11. A method of adjusting a height of protrusions (24) on a support surface of a support table (WT, MT) for holding an article (W, MA) with a planar surface in a predetermined plane transverse to a beam path in a lithographic projection apparatus, the support table (WT, MT) comprising at least a chuck and a table surface element mounted on the chuck, the surface element comprising an array of protrusions (24), of which at least a top is integrally made of protrusion material, the protrusions (24) extending from the support surface for supporting the article (W, MA), the method comprising the steps of:
- measuring height deviations of respective ones of the protrusions (24) that affect a surface flatness of the planar surface of the article (W, MA) when the surface element is mounted on the chuck;
- adjusting a height of protrusion material, corresponding to the detected height deviations of respective ones of the protrusions (24) selectively at the respective ones of the protrusions (24), while the surface element remains mounted on the chuck, **characterized in that** the method comprises removing protrusion material corresponding to the detected height deviations of respective ones of the protrusions (24) and/or heating the protrusion material to cause an at least semi-permanent swelling of protrusion material to produce height increases corresponding to the detected height deviations of respective ones of the protrusions (24).

12. A method according to claim 11, wherein the measuring and height adjustment steps are executed while the support table (WRT, N1T) is in an operable position in the lithographic projection apparatus.

13. A method according to claim 11, wherein the measuring step comprises
- placing an article (W, MA) on the support table (WT, MT), supported by protrusions (24)
- measuring a height profile of the planar surface of the article (W, MA) on a side facing away from the protrusions (24)
- computing the height deviations of the protrusions (24) from the height profile.

## Patentansprüche

1. Ein lithographisches Projektionsgerät, das Folgendes beinhaltet:
- ein Strahlproduktionssystem (SO, BD, IL) zum Bereitstellen eines Projektionsstrahls aus Strahlung, Mustern des Strahls und Projizieren des gemusterten Strahls auf einen Zielabschnitt eines Substrats (W);
- einen Stütztisch (WT, MT) zum Stützen eines Gegenstands (W, MA), so dass eine ebene Oberfläche des Gegenstands (W, MA) in einer zuvor festgelegten Ebene liegt, die zu einer Ausbreitungsrichtung des Projektionsstrahls quer verläuft, wobei der Stütztisch (WT, MT) eine Stützoberfläche und eine Gruppierung von Vorsprüngen (24), die sich von der Stützoberfläche erstrecken, aufweist, um den Gegenstand (W, MA) auf den Vorsprüngen (24) zu stützen, wobei mindestens ein oberes Ende jedes Vorsprungs (24) im Wesentlichen aus einem integralen Vorsprungsmaterial gebildet ist, **dadurch gekennzeichnet, dass** das lithographische Projektionsgerät ferner Folgendes beinhaltet:
- einen Detektor (50, DE) zum Erfassen von Höhenabweichungen von jeweiligen der Vorsprünge (24), die eine Oberflächenflachheit des Gegenstands (W, MA) beeinflussen;
- eine positionsselektive Höheneinstellvorrichtung (54), die eingerichtet ist, um unabhängig auf individuelle Vorsprünge (24) zu wirken, wenn der Stütztisch (WT) in dem Gerät betriebsbereit ist, um eine Höhe des Vorsprungsmaterials des individuellen Vorsprungs (24) zu modifizieren, wobei die positionsselektive Höheneinstellvorrichtung (54) eingerichtet ist, um Material von den jeweiligen der Vorsprünge (24) zu entfernen oder/oder ihnen Material hinzuzufügen; und
- eine Steuereinheit (52), die zwischen den Detektor (50, DE) und die positionsselektive Höheneinstellvorrichtung (54) gekoppelt und eingerichtet ist, um die positionsselektive Höheneinstellvorrichtung (54) zu steuern, um die Höhe des Vorsprungsmaterials, die jeweiligen erfassten Höhenabweichungen von jeweiligen der Vorsprünge entspricht, einzustellen.

2. Lithographisches Projektionsgerät gemäß Anspruch 1, wobei die positionsselektive Höheneinstellvorrichtung (54) eingerichtet ist, um Material von den jeweiligen der Vorsprünge zu entfernen.

3. Lithographisches Projektionsgerät gemäß Anspruch 2, wobei die positionsselektive Höheneinstellvorrichtung (54) eingerichtet ist, um zu bewirken, dass Material von jeweiligen der Vorsprünge (24) eine mindestens halbpermanente angeschwollene Phase annimmt, die die Höhe des individuellen Vorsprungs (24) steigert.

4. Lithographisches Projektionsgerät gemäß Anspruch 1, wobei der Gegenstand das Substrat (W) oder ein Retikel oder eine Maske (MA), das/die zum Mustern des Strahls verwendet wird, ist.

5. Lithographisches Projektionsgerät gemäß Anspruch 1, wobei die positionsselektive Höheneinstellvorrichtung (54) eingerichtet ist, um den jeweiligen der Vorsprünge Material hinzuzufügen.

6. Lithographisches Projektionsgerät gemäß Anspruch 2, wobei die positionsselektive Höheneinstellvorrichtung (54) eingerichtet ist, um eine einstellbare Entfernungsstärke zu unterstützen, wobei die Steuereinheit (52) zwischen einem ersten Modus, in dem die Entfernungsstärke der positionsselektiven Höheneinstellvorrichtung (54) auf über einem ersten Niveau festgesetzt ist, welches ausreicht, um den Teil des Vorsprungsmaterials zu entfernen, und einem zweiten Modus, in dem die Entfernungsstärke auf unter ein zweites Niveau festgesetzt ist, welches nicht ausreicht, um den Teil des Vorsprungsmaterials zu entfernen, welches aber ausreicht, um Verunreinigungen aus anderem Material von den Vorsprüngen (24) zu entfernen, geschaltet werden kann.

7. Lithographisches Projektionsgerät gemäß Anspruch 2, wobei die positionsselektive Höheneinstellvorrichtung (54) einen Laser (40) beinhaltet, der eingerichtet ist, um einen Strahl auf auswählbare der Vorsprünge (24) zu projizieren, mit einer Intensität, die ausreicht, um ein Entfernen von Vorsprungsmaterial von dem Vorsprung (24) zu verursachen, wobei die Steuereinheit (52) eingerichtet ist, um jeweilige angehäufte Leistungsdosen, die von dem Laser (40) an die jeweiligen der Vorsprünge (24) geliefert werden, abhängig von den für die jeweiligen der Vorsprünge (24) gemessenen Höhenabweichungen zu steuern.

8. Lithographisches Projektionsgerät gemäß Anspruch 2, wobei die positionsselektive Höheneinstellvorrichtung (54) einen Laser (40) beinhaltet, der eingerichtet ist, um einen Strahl auf auswählbare der Vorsprünge (24) zu projizieren, mit einem Intensitätsniveau, das ausgewählt ist, um das Vorsprungsmaterial zu erhitzen, so dass es nach dem Abkühlen eine mindestens halbpermanent angeschwollene Phase annimmt, wobei die Steuereinheit (52) eingerichtet ist, um eine Energiedichte, die von dem Laser (40) an die jeweiligen der Vorsprünge (24) geliefert wird, abhängig von den für die jeweiligen der Vorsprünge (24) gemessenen Höhenabweichungen zu steuern.

9. Lithographisches Projektionsgerät gemäß Anspruch 1, wobei der Detektor (50, DE) Folgendes beinhaltet:
- eine Messeinheit (50, DE) zum Messen eines Höhenprofils der ebenen Oberfläche des Gegenstands (W, MA), die einer weiteren Oberfläche des Gegenstands, welche von dem Stütztisch (WT, MT) gestützt wird, entgegengesetzt ist;
- eine Berechnungseinheit (52), die eingerichtet ist, um die Höhenabweichungen der Vorsprünge (24) aus dem Höhenprofil zu berechnen, wobei die Steuereinheit (52) die Material entfernende und/oder hinzufügende Vorrichtung abhängig von der Höhenabweichung steuert.

10. Lithographisches Projektionsgerät gemäß Anspruch 1, wobei die positionsselektive Höheneinstellvorrichtung (54) eine Einheit für lokalisierte Materialablagerung beinhaltet, wobei mindestens eines von dem Stütztisch (WT, MT) und der Ablagerungseinheit unter Steuerung der Steuereinheit (52) relativ zu dem anderen beweglich ist.

11. Ein Verfahren zum Einstellen einer Höhe von Vorsprüngen (24) auf einer Stützoberfläche eines Stütztisches (WT, MT) zum Halten eines Gegenstands (W, MA) mit einer ebenen Oberfläche in einer zuvor festgelegten Ebene, die zu einem Strahlweg in einem lithographischen Projektionsgerät quer verläuft, wobei der Stütztisch (WT, MT) mindestens eine Aufspannvorrichtung und ein Tischoberflächenelement, das auf der Aufspannvorrichtung montiert ist, beinhaltet, wobei das Oberflächenelement eine Gruppierung von Vorsprüngen (24) beinhaltet, von denen mindestens ein oberes Ende integral aus einem Vorsprungsmaterial gefertigt ist, wobei sich die Vorsprünge (24) zum Stützen des Gegenstands (W, MA) von der Stützoberfläche erstrecken, wobei das Verfahren die folgenden Schritte beinhaltet:
- Messen von Höhenabweichungen von jeweiligen der Vorsprünge (24), die eine Oberflächenflachheit der ebenen Oberfläche des Gegenstands (W, MA) beeinflussen, wenn das Oberflächenelement auf der Aufspannvorrichtung montiert ist;
- selektives Einstellen einer Höhe von Vorsprungsmaterial entsprechend den erfassten Höhenabweichungen von jeweiligen der Vorsprünge (24) an den jeweiligen der Vorsprünge (24), während das Oberflächenelement auf der Aufspannvorrichtung montiert bleibt, **dadurch gekennzeichnet, dass** das Verfahren das Entfernen von Vorsprungsmaterial entsprechend den erfassten Höhenabweichungen von jeweiligen der Vorsprünge (24) und/oder das Erhitzen des Vorsprungsmaterials, um ein mindestens halbpermanentes Anschwellen des Vorsprungsmaterials zu verursachen, um Höhenzunahmen entsprechend den erfassten Höhenabweichungen von jeweiligen der Vorsprünge (24) zu produzieren, beinhaltet.

12. Verfahren gemäß Anspruch 11, wobei die Schritte des Messens und der Höheneinstellung ausgeführt werden, während sich der Stütztisch (WRT, MT) in einer betriebsbereiten Position in dem lithographischen Projektionsgerät befindet.

13. Verfahren gemäß Anspruch 11, wobei der Messschritt Folgendes beinhaltet:
- Platzieren eines Gegenstands (W, MA) auf dem Stütztisch (WT, MT), gestützt von Vorsprüngen (24),
- Messen eines Höhenprofils der ebenen Oberfläche des Gegenstands (W, MA) auf einer Seite, die von den Vorsprüngen (24) weg weist;
- Berechnen der Höhenabweichungen der Vorsprünge (24) aus dem Höhenprofil.

## Revendications

1. Un appareil de projection lithographique comprenant :
- un système de production de faisceau (SO, BD, IL) destiné à fournir un faisceau de projection de rayonnement, conformer le faisceau selon un motif et projeter le faisceau à motif sur une portion cible d'un substrat (W) ;
- une table formant support (WT, MT) destinée à soutenir un article (W, MA) de sorte qu'une surface planaire de l'article (W, MA) se trouve dans un plan prédéterminé transversal à une direction de propagation du faisceau de projection, la table formant support (WT, MT) ayant une surface de support et une matrice de saillies (24) s'étendant à partir de la surface de support, de manière à soutenir l'article (W, MA) sur les saillies (24), un sommet de chaque saillie (24) au moins étant formé substantiellement en un matériau de saillie solidaire, **caractérisé en ce que** l'appareil de projection lithographique comprend de plus
- un détecteur (50, DE) destiné à détecter des écarts de hauteur de saillies respectives d'entre les saillies (24) qui affectent une planéité de surface de l'article (W, MA) ;
- un dispositif d'ajustement de hauteur sélectif suivant la position (54), arrangé pour agir indépendamment sur des saillies individuelles (24) lorsque la table formant support (WT) est manipulable dans l'appareil, afin de modifier une hauteur du matériau de saillie de la saillie individuelle (24), le dispositif d'ajustement de hauteur sélectif suivant la position (54) étant arrangé pour enlever et / ou ajouter du matériau à ces saillies respectives d'entre les saillies (24) ; et
- une unité de commande (52) couplée entre le détecteur (50, DE) et le dispositif d'ajustement de hauteur sélectif suivant la position (54) et arrangée pour commander le dispositif d'ajustement de hauteur sélectif suivant la position (54) afin d'ajuster la hauteur du matériau de saillie correspondant à des écarts de hauteur détectés respectifs de saillies respectives d'entre les saillies.

2. Un appareil de projection lithographique selon la revendication 1, dans lequel le dispositif d'ajustement de hauteur sélectif suivant la position (54) est arrangé pour enlever du matériau à ces saillies respectives d'entre les saillies.

3. Un appareil de projection lithographique selon la revendication 2, dans lequel le dispositif d'ajustement de hauteur sélectif suivant la position (54) est arrangé pour faire prendre au matériau de saillies respectives d'entre les saillies (24) une phase de gonflement au moins semi-permanent qui augmente la hauteur de la saillie individuelle (24).

4. Un appareil de projection lithographique selon la revendication 1, dans lequel l'article est le substrat (W) ou un réticule ou masque (MA) qui est utilisé pour conformer le faisceau selon un motif.

5. Un appareil de projection lithographique selon la revendication 1, dans lequel le dispositif d'ajustement de hauteur sélectif suivant la position (54) est arrangé pour ajouter du matériau à ces saillies respectives d'entre les saillies.

6. Un appareil de projection lithographique selon la revendication 2, dans lequel le dispositif d'ajustement de hauteur sélectif suivant la position (54) est arrangé pour supporter une force d'enlèvement ajustable, l'unité de commande (52) étant commutable entre un premier mode dans lequel la force d'enlèvement du dispositif d'ajustement de hauteur sélectif suivant la position (54) est réglée au-dessus d'un premier niveau suffisant pour enlever la partie du matériau de saillie et un deuxième mode dans lequel la force d'enlèvement est réglée en dessous d'un deuxième niveau qui est insuffisant pour enlever la partie du matériau de saillie, mais suffisant pour enlever, des saillies (24), des impuretés d'autre matériau.

7. Un appareil de projection lithographique selon la revendication 2, dans lequel le dispositif d'ajustement de hauteur sélectif suivant la position (54) comprend un laser (40), arrangé pour projeter un faisceau sur des saillies sélectionnables d'entre les saillies (24), avec une intensité suffisante pour occasionner l'enlèvement de matériau de saillie de la saillie (24), l'unité de commande (52) étant arrangée pour commander des doses de puissance accumulée respectives délivrées par le laser (40) à ces saillies respectives d'entre les saillies (24) en fonction des écarts de hauteur mesurés pour ces saillies respectives d'entre les saillies (24).

8. Un appareil de projection lithographique selon la revendication 2, dans lequel le dispositif d'ajustement de hauteur sélectif suivant la position (54) comprend un laser (40), arrangé pour projeter un faisceau sur des saillies sélectionnables d'entre les saillies (24), avec un niveau d'intensité sélectionné pour chauffer le matériau de saillie de sorte qu'il prenne une phase de gonflement au moins semi-permanent après refroidissement, l'unité de commande (52) étant arrangée pour commander une densité d'énergie délivrée par le laser (40) à ces saillies respectives d'entre les saillies (24) en fonction des écarts de hauteur mesurés pour ces saillies respectives d'entre les saillies (24).

9. Un appareil de projection lithographique selon la revendication 1, dans lequel le détecteur (50, DE) comprend
- une unité de mesure (50, DE) destinée à mesurer un profil de hauteur de la surface planaire de l'article (W, MA) opposée à une autre surface de l'article qui est soutenue par la table formant support (WT, MT) ;
- une unité de calcul (52) arrangée pour calculer les écarts de hauteur des saillies (24) d'après le profil de hauteur, l'unité de commande (52) commandant le dispositif d'enlèvement et / ou d'ajout de matériau en fonction de l'écart de hauteur.

10. Un appareil de projection lithographique selon la revendication 1, dans lequel le dispositif d'ajustement de hauteur sélectif suivant la position (54) comprend une unité de dépôt de matériau localisé, au moins soit la table formant support (WT, MT), soit l'unité de dépôt pouvant être déplacée par rapport à l'autre sous la commande de l'unité de commande (52).

11. Un procédé pour ajuster une hauteur de saillies (24) sur une surface de support d'une table formant support (WT, MT) destinée à porter un article (W, MA) avec une surface planaire dans un plan prédéterminé transversal à un trajet de faisceau dans un appareil de projection lithographique, la table formant support (WT, MT) comprenant au moins un mandrin et un élément de surface de table monté sur le mandrin, l'élément de surface comprenant une matrice de saillies (24), dont au moins un sommet est réalisé solidairement en matériau de saillie, les saillies (24) s'étendant à partir de la surface de support pour soutenir l'article (W, MA), le procédé comprenant les étapes de :
- mesurer des écarts de hauteur de saillies respectives d'entre les saillies (24) qui affectent une planéité de surface de la surface planaire de l'article (W, MA) lorsque l'élément de surface est monté sur le mandrin ;
- ajuster une hauteur de matériau de saillie, correspondant aux écarts de hauteur détectés de saillies respectives d'entre les saillies (24) de manière sélective au niveau de ces saillies respectives d'entre les saillies (24), tandis que l'élément de surface reste monté sur le mandrin, **caractérisé en ce que** le procédé comprend le fait d'enlever du matériau de saillie correspondant aux écarts de hauteur détectés de saillies respectives d'entre les saillies (24) et / ou le fait de chauffer le matériau de saillie pour occasionner un gonflement au moins semi-permanent de matériau de saillie afin de produire des augmentations de hauteur correspondant aux écarts de hauteur détectés de saillies respectives d'entre les saillies (24).

12. Un procédé selon la revendication 11, dans lequel les étapes de mesure et d'ajustement de hauteur sont exécutées tandis que la table formant support (WRT, MT) se trouve dans une position dans laquelle elle est manipulable dans l'appareil de projection lithographique.

13. Un procédé selon la revendication 11, dans lequel l'étape de mesure comprend
- placer un article (W, MA) sur la table formant support (WT, MT), soutenu par des saillies (24)
- mesurer un profil de hauteur de la surface planaire de l'article (W, MA) sur un côté tournant le dos aux saillies (24)
- calculer les écarts de hauteur des saillies (24) d'après le profil de hauteur.
